# FASCICULE DE BREVET EUROPEEN

(11) **EP 4 174 578 B1**
(45) Date de publication et mention de la délivrance du brevet: **15.07.2026**
(21) Numéro de dépôt: 22203858.0
(22) Date de dépôt: 26.10.2022
(51) Int. Cl.: G03F 7/20, G03F 9/00, G03F 7/00

(54) **STRUCTURE DE METROLOGIE**
METROLOGIESTRUKTUR
METROLOGY STRUCTURE

(30) Priorité: 02.11.2021 FR 2111619
(43) Date de publication de la demande: 03.05.2023
(73) Titulaire: Commissariat à l'Energie Atomique et aux Energies Alternatives, 75015 Paris (FR)
(72) Inventeur: BLANCQUAERT, Yoann, 38054 GRENOBLE CEDEX 09 (FR); DUBREUIL, Olivier, 38054 GRENOBLE CEDEX 09 (FR)
(74) Mandataire: Santarelli

(56) Documents cités:
- EP-B1- 1 314 198
- FR-A1- 2 877 767
- JP-B2- 4 013 727
- US-A1- 2010 103 433
- US-A1- 2010 190 096
- US-A1- 2016 061 589
- US-A1- 2016 179 017
- US-A1- 2020 201 193
- US-A1- 2020 218 167
- US-B1- 7 408 642

## Description

### DOMAINE TECHNIQUE

La présente demande a trait au domaine de la fabrication de dispositifs en couches minces tels que les dispositifs microélectroniques et/ou les microsystèmes et concerne plus précisément une nouvelle structure de métrologie adaptée à la détermination ou la mesure de paramètres tels que la dimension critique, le recouvrement (overlay) et le focus utilisés lors des procédés de fabrication en couches minces en particulier lors d'étapes de photolithographie.

### ÉTAT DE LA TECHNIQUE ANTÉRIEURE

Pour réaliser un dispositif en couche minces sur un substrat et en particulier un dispositif microélectronique ou un microsystème on utilise couramment des procédés de photolithographie permettant de former des motifs en réalisant ces derniers tout d'abord dans une couche de matériau photosensible avant de les transférer dans la couche mince à structurer.

Il est souhaitable d'effectuer fréquemment des mesures sur le dispositif en cours de réalisation ou sur un étalon en particulier pour le contrôle et la vérification d'un procédé de photolithographie. Plusieurs paramètres intrinsèques à un équipement de photolithographie peuvent influencer le procédé de photolithographie et doivent être suivis.

Parmi les paramètres mesurés, on compte notamment la mesure de dimension critique CD (pour « Critical Dimension ») qui est la plus petite dimension de motifs structurés hormis leur épaisseur et qui correspond typiquement à leur largeur. Un tel paramètre varie en fonction de la dose d'exposition au rayonnement lumineux utilisé, typiquement UV et de la mise au point (focus).

Différentes méthodes permettent d'effectuer une mesure de dimension critique. Un premier type de méthode appelée CD-SEM (pour « Critical Dimension- Scanning Electron Measurement ») décrite par exemple dans le document US 552 3567A est basée sur l'imagerie électronique. Un faisceau d'électrons est mis en forme et focalisé sur une surface d'un échantillon de manière à balayer une surface de cet échantillon. Au cours de ce balayage, des électrons réémis sont détectés par un détecteur ayant un fonctionnement semblable à celui d'un scintillateur.

Un deuxième type de méthode appelée « scatterométrie » et décrite par exemple dans les documents US20160076876A1, EP2486378A1, EP1628164B1, US2010/103433A1 est fondée sur l'analyse

d'une lumière diffusée. Une telle technique repose en outre sur l'association d'une mesure physique par réflectométrie et d'une modélisation mathématique. La structure à analyser est illuminée par une source lumineuse de gamme spectrale pouvant aller de l'ultraviolet (UV) à l'infrarouge (IR). Un faisceau lumineux incident d'intensité I0 est émis sur la structure et subit principalement deux modifications physiques : la diffraction et l'interaction avec la structure. Un détecteur collecte des intensités Ir de différents ordres de diffraction.

Un troisième type de méthode, reposant sur une analyse d'interaction atomique, est décrit par exemple dans le document US4724318A. Le principe réside dans l'interaction atomique entre une pointe et une surface d'une structure à mesurer. La structure est balayée par cette pointe qui suit la topographie de la surface. La position de la pointe, peut être détectée grâce à la réflexion d'un laser. Une photodiode permet de collecter et positionner le signal lumineux réfléchi. Par le biais d'un tel signal, on peut remonter aux variations de la position de la pointe et ainsi à une valeur de dimension critique.

Pour les deux premières méthodes on prévoit de diriger un faisceau lumineux ou de particules sur une structure de métrologie spécifique comportant des motifs prédéterminés particuliers afin d'étalonner un équipement et/ou vérifier la fiabilité d'un procédé. Pour la troisième méthode, une structure de métrologie peut également être employée et se présenter sous forme d'un réseau de lignes sondé grâce à des pointes calibrées.

Un autre paramètre communément appelé « overlay » (recouvrement) est évalué afin de vérifier le bon positionnement d'un niveau par rapport au(x) niveau(x) inférieur(s) d'un même empilement de couches minces.

Un tel paramètre est défini précisément par le standard SEMI P18-92 comme une grandeur vectorielle égale à la différence entre un vecteur position : →̅*̅P̅*̅1̅ d'une structure au niveau substrat et un vecteur position : →̅*̅P̅*̅2̅ de la même structure au niveau d'une couche réalisée lors d'une étape courante typiquement de photolithographie.

La mesure de ce paramètre peut être réalisée par une technique utilisant la diffraction, telle que décrite par exemple dans les documents US8670118B2 ou EP1601931B1.

La détermination du recouvrement (overlay) peut être également réalisée à l'aide d'une technique d'imagerie utilisant des mesures effectuées sur une structure de métrologie dédiée et placée sur un circuit intégré en cours de réalisation.

Un autre paramètre que l'on souhaite pouvoir détecter est le focus. Au cours d'un procédé de photolithographie, un système d'éclairage projette dans une couche de matériau photosensible une image d'un réticule au travers d'un objectif. Les caractéristiques de l'image projetée peuvent varier à travers l'épaisseur de la couche de matériau photosensible mais aussi, selon la topographie du support de la couche photosensible. Par conséquent, la position focale photo-lithographique est définie comme une position par rapport à une hauteur référence qui est celle de la surface de la couche de matériau photosensible. Par exemple, pour une hauteur HT de matériau photosensible, le focus sera défini comme étant à une hauteur HTk compris dans l'intervalle [0;HT], pour laquelle l'image obtenue aura le meilleur contraste.

Pour déterminer le focus, il est connu d'utiliser sur un masque de photolithographie des mires en forme de peigne.

Il existe un besoin d'une structure de métrologie adaptée à plusieurs des techniques précitées.

Il existe également un besoin d'une structure de métrologie permettant d'effectuer une mesure ou de détecter, de préférence à temps de mesure constant et à partir d'un même équipement, plusieurs voire l'ensemble des paramètres précités.

Le document US2016/179017 A1 présente une structure de métrologie d'imagerie munie d'une cible fournissant un signal bidimensionnel. La structure décrite permet de mesurer un seul paramètre métrologique : celui de recouvrement (overlay).

Il se pose le problème de trouver une nouvelle structure de métrologie qui soit compatible avec la mesure de plusieurs paramètres.

### EXPOSÉ DE L'INVENTION

Selon un mode de réalisation, la présente invention concerne une structure de métrologie formée sur au moins un support et dotée de cibles élémentaires identiques, chaque cible élémentaire comprenant un premier motif et un deuxième motif superposés selon la revendications indépendante de dispositif 1.

Avec une telle structure et la présence d'une telle cible répétée on peut à la fois réaliser des mesures de dimension critique, d'overlay et de focus.

Des dimensions différentes des dents au niveau d'un réticule peuvent permettre d'obtenir des formes de structures différentes lorsque, après exposition par l'outil de photolithographie, la structure de métrologie est reportée au niveau d'une plaque (« wafer » selon la terminologie anglo-saxonne).

Avantageusement, au moins un autre segment orthogonal au segment donné forme un peigne muni de dents réparties de part et d'autre dudit autre segment.

Selon un mode de réalisation avantageux de la structure de métrologie, dans la première direction, le premier motif et le deuxième motif peuvent être répétés selon un même premier pas de répartition tandis que dans la deuxième direction, le premier motif et le deuxième motif sont répétés selon un même deuxième pas de répartition, ledit premier pas de répartition étant différent dudit deuxième pas de répartition. Un tel agencement permet de réaliser un détrompeur et permettre de distinguer une orientation selon la première direction d'une orientation selon la deuxième direction.

Avantageusement, dans la première direction, un deuxième motif d'une première cible élémentaire peut être relié à un deuxième motif d'une deuxième cible élémentaire tandis que dans la deuxième direction, ledit deuxième motif de ladite première cible élémentaire et un autre deuxième motif d'une troisième cible élémentaire sont disjoints. Là encore, un tel agencement peut permettre de réaliser un détrompeur

Selon une possibilité de mise en œuvre, le deuxième motif de ladite première cible élémentaire et le premier motif de la deuxième cible élémentaire peuvent être espacés d'une première distance tandis que la deuxième direction, le deuxième motif de la première cible élémentaire et ledit autre deuxième motif de ladite troisième cible élémentaire sont espacés d'une deuxième distance différente de la première distance. Un tel agencement peut également permettre de réaliser un détrompeur.

Un mode de réalisation avantageux prévoit que le premier ensemble de segments du premier motif est formé dans la première direction de segments espacés entre eux d'une distance donnée tandis que dans la deuxième direction le premier motif est formé de segments espacés d'une autre distance distincte de ladite distance donnée.

En variante, le premier motif peut être prévu de sorte que le premier ensemble de segments est formé, dans la première direction, de segments espacés entre eux d'une distance donnée et dans la deuxième direction de segments continus.

Selon une possibilité de mise en œuvre de la structure de métrologie, le premier segment et le deuxième segment ont des largeurs respectives différentes, et/ou dans lequel les segments du premier ensemble de segments ont une première largeur dans la première direction et une deuxième largeur dans la deuxième direction. Un tel agencement peut également permettre de réaliser un détrompeur.

Selon une possibilité de mise en œuvre de la structure de métrologie, ledit premier ensemble de segments et le deuxième ensemble de segments peuvent être répartis de sorte qu'un axe orthogonal au support et passant par ledit point donné, passe également par un point central dudit contour polygonal.

Le support peut être un substrat sur lequel un empilement de couches minces est formé, le premier motif étant réalisé dans une première couche mince dudit empilement, le deuxième motif étant réalisé dans une deuxième couche mince dudit empilement. La structure de métrologie peut être ainsi intégrée à un dispositif en cours de réalisation voire un dispositif destiné à servir d'étalon.

Selon un autre aspect, la présente invention comprend un ensemble de masques de photolithographie formant une structure de métrologie telle que décrite précédemment. Selon un autre aspect, la présente invention concerne un procédé de fabrication d'un dispositif microélectronique ou d'un micro-système comprenant au moins une étape de mesure de dimension critique ou de recouvrement (overlay) ou une étape de détection de focus d'un appareil de photolithographie au moyen d'une structure de métrologie telle que définie plus haut.

### BRÈVE DESCRIPTION DES DESSINS

La présente invention sera mieux comprise sur la base de la description qui va suivre et des dessins en annexe sur lesquels :
Figure 1 sert à illustrer un premier exemple de structure de métrologie suivant la présente invention.
Figure 2 sert à illustrer un premier exemple de cible susceptible d'être intégrée dans une structure de métrologie ou de former une structure de métrologie suivant l'invention.
Figure 3 sert à illustrer une superposition de niveaux technologiques dans lesquelles des mires d'une structure de métrologie selon l'invention peuvent être réparties.
Figures 4A-4D servent à illustrer différents agencements de segments d'une cible élémentaire de structure de métrologie.
Figures 5 et 6 servent à illustrer une première variante de cible élémentaire d'une structure de métrologie selon l'invention.
Figure 7 sert à illustrer une variante de cible élémentaire selon l'invention.
Figure 8 sert à illustrer un deuxième exemple de structure de métrologie selon l'invention.
Figure 9 sert à illustrer un troisième exemple de structure de métrologie selon l'invention.
Figure 10 sert à illustrer un quatrième exemple de structure de métrologie selon l'invention.
Figure 11 sert à illustrer un cinquième exemple de structure de métrologie selon l'invention.
Figure 12 sert à illustrer un sixième exemple de structure de métrologie selon l'invention.
Figure 13 sert à illustrer un sixième exemple de structure de métrologie selon l'invention.
Figure 14 sert à illustrer un septième exemple de structure de métrologie selon l'invention.
Figure 15 sert à illustrer un huitième exemple de structure de métrologie selon l'invention.
Figure 16 sert à illustrer une structure de métrologie selon l'invention lorsque soumise à un faisceau de rayonnement lumineux.
Figure 17 sert à illustrer un neuvième exemple de structure de métrologie selon l'invention.
Figure 18 sert à illustrer un dixième exemple de structure de métrologie selon l'invention.
Figure 19 sert à illustrer un onzième exemple de structure de métrologie selon l'invention.
Figure 20 sert à illustrer un douzième exemple de structure de métrologie selon l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « supérieur », « inférieur », « centrale », « périphérique » s'appliquent en considérant que la structure est orientée de la façon illustrée sur les figures.

### EXPOSÉ DÉTAILLÉ DE MODES DE RÉALISATION PARTICULIERS

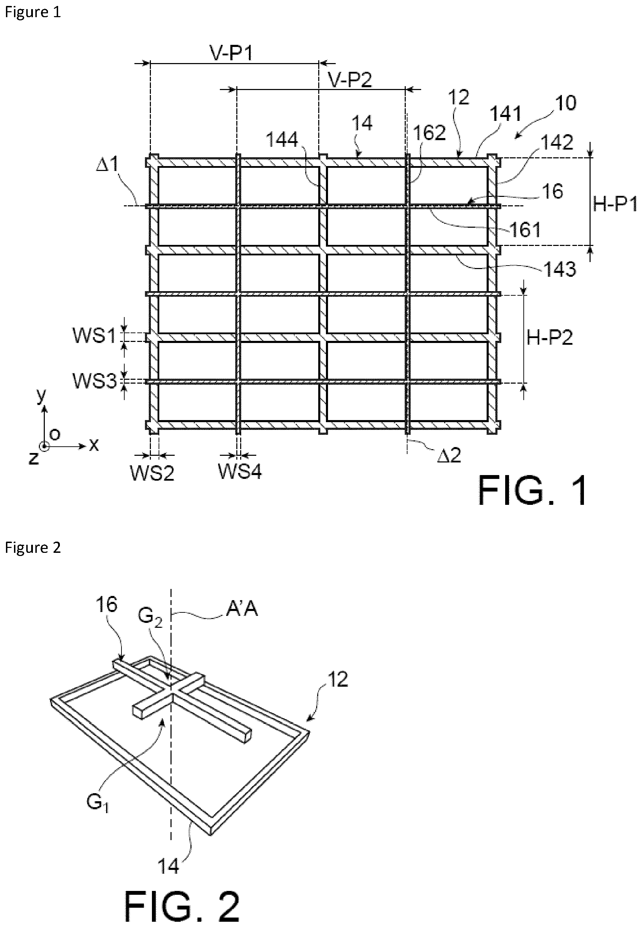

On se réfère à présent aux figures 1, 2 illustrant (par le biais respectivement d'une vue de dessus et d'une vue en perspective) un premier exemple de structure de métrologie 10 suivant l'invention.

Cette structure 10 est susceptible d'être utilisée pour effectuer des mesures de dimension critique, et/ou de détection de défauts de recouvrement (overlay) et/ou pour la détermination du focus d'un équipement de photolithographie. De telles étapes de mesure ou de détection peuvent être utilisées lors de la fabrication d'un dispositif microélectronique ou microsystème réalisé en couches minces. De telles étapes peuvent être également mises en œuvre pour effectuer une calibration d'équipement.

De telles étapes de mesure ou de détection ou de détermination peuvent être réalisées par voie optique en projetant sur la structure 10 de métrologie un rayonnement lumineux émanant d'une source d'un équipement de mesure. Le rayonnement lumineux a une d'onde qui peut être situé entre le domaine UV et infra-rouge. Ainsi, la structure de métrologie 10 est notamment susceptible d'être utilisée pour pouvoir effectuer des mesures par scattérométrie basées sur l'analyse d'une lumière diffusée suite à l'émission d'un rayonnement lumineux sur cette structure 10.

Des mesures effectuées en projetant sur la structure 10 un faisceau de particules, par exemple d'électrons peuvent être également mises en œuvre, en particulier lorsqu'il s'agit de mesurer une dimension critique. Un tel type de structure 10 est également susceptible d'être utilisée afin d'effectuer des mesures de dimensions critique de type CD-SEM autrement dit en utilisant un microscope électronique à balayage (MEB).

Une structure de métrologie suivant l'invention est formée de plusieurs cibles élémentaires identiques susceptibles de former des mires optiques.

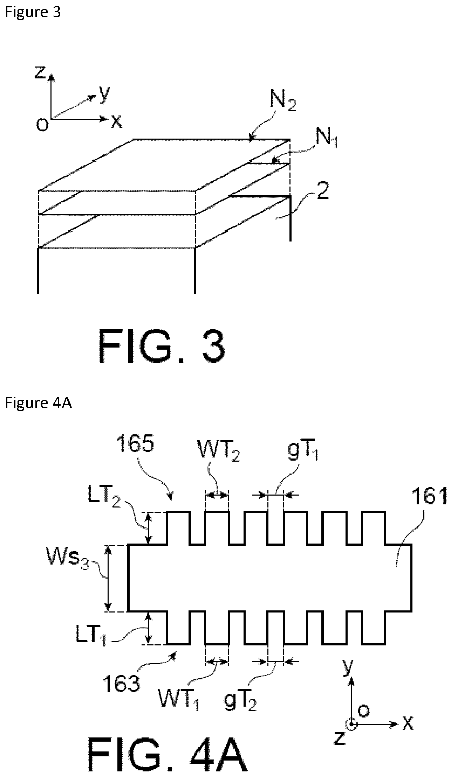

Dans l'exemple de réalisation illustré sur la figure 1, la structure 10 est pourvue d'un agencement matriciel de cibles élémentaires 12 identiques réparties sur plusieurs rangées. Chaque cible élémentaire 12 est ici réalisée sur plusieurs niveaux, par exemple sur plusieurs niveaux de couches minces d'un dispositif de type microélectronique ou d'un microsystème en cours de réalisation. Typiquement, la cible élémentaire 12 est réalisée sur deux niveaux N₁ et N₂ superposés comme cela est illustré de manière schématique et à titre d'exemple sur l'empilement de la figure 3 reposant sur un substrat 2. Par dispositif « microélectronique », on entend ici un dispositif muni de composants électroniques à l'échelle micrométrique et/ou nanométrique et typiquement fabriqué à partir de matériaux semi-conducteurs. Par « microsystème » on entend un dispositif comportant des composants ou capteurs, par exemple optique(s) et/ou électromécanique(s), de taille micrométrique et/ou nanométrique. Il est également possible de prévoir une telle structure sur un dispositif étalon réalisé en couches minces sur un substrat, éventuellement dépourvu de composant ou de composant fonctionnel, mais servant de référence pour effectuer l'étalonnage d'un équipement, et en particulier un équipement de photolithographie.

Chaque cible élémentaire 12 comporte un premier motif 14 formé d'un premier ensemble de segments 141, 142, 143, 144 réalisés dans un premier niveau N₁ du dispositif microélectronique. Les segments sont typiquement des portions allongées, par exemple de forme parallélépipédique ou sensiblement parallélépipédique d'un matériau donné qui peut être par exemple métallique ou semi-conducteur, voire un matériau photosensible tel qu'une résine photosensible ou un matériau susceptible d'être utilisé dans le cadre d'un procédé de photolithographie. Par exemple, ce premier niveau N₁ peut être : celui dans lequel des grilles de transistors sont prévues, ou bien, celui dans lequel des contacts de transistors sont formés, voire un niveau métallique d'interconnexion.

Chaque cible élémentaire 12 comporte également un deuxième motif 16 formé d'un ensemble de segments 161, 162 réalisés dans un deuxième niveau N₂ du dispositif et situé par rapport au substrat 2 au-dessus du premier niveau N₁. Le premier niveau N₁ et le deuxième niveau N₂ ne sont pas nécessairement des niveaux consécutifs d'un empilement de couches mince et ne correspondent pas nécessairement non plus au tout premier et au niveau suivant ce tout premier niveau d'un empilement de couches minces. Par exemple, ce deuxième niveau N₂ peut être celui dans lequel des contacts de transistors, en particulier lorsque le premier niveau N₁ est celui des grilles de transistors. **En** variante, le deuxième niveau N₂ peut être un niveau métallique d'interconnexion en particulier lorsque le premier niveau N₁ est celui des contacts ou bien un niveau métallique inférieur.

Les segments 141, 142, 143, 144 réalisant le premier motif 14 sont agencés parallèlement ou sensiblement parallèlement à un premier plan (plan situé au niveau N1 et parallèle au plan [O ;x ;y] du repère orthogonal [O ;x ;y ;z] sur la figure 2) et sont ici répartis le long des arêtes d'un polygone.

Par « sensiblement parallèle » on entend ici et tout au long de la description qui réalisent entre eux un angle très faible et en particulier inférieur à 10°, de préférence inférieur à 6°. L'ensemble des segments 141, 142, 143, 144 présente une symétrie selon un premier axe Δ1 situé dans le premier plan et une symétrie selon un deuxième axe Δ2 également situé dans le premier plan, le deuxième axe Δ2 étant orthogonal au premier axe Δ1.

Dans cet exemple de réalisation particulier, les segments 141, 142, 143, 144 forment un contour fermé de forme rectangulaire. Une telle forme rectangulaire présente, par rapport à une forme carrée, pour avantage de pouvoir servir plus aisément de repère d'orientation et de permettre de distinguer par exemple une orientation selon une direction horizontale d'une orientation selon une direction verticale.

Les segments 141, 143 qui s'étendent dans une première direction parallèlement au premier axe Δ1 peuvent être prévus avec une largeur WS1 (dimension mesurée parallèlement au plan [O ;x ;y ] et en particulier à l'axe y du repère orthogonal [O ;x ;y ;z]) comprise par exemple entre 10 nanomètres et 2 µm. La largeur WS1 sera adaptée par l'homme du métier en fonction de la dimension minimale du nœud technologique pour la valeur minimale, et de la taille d'un faisceau de l'outil de scattérométrie divisée sensiblement par 20 pour la taille maximale. Les segments 142, 144 qui s'étendent dans une deuxième direction, orthogonalement à la première direction et parallèlement au deuxième axe Δ2 peuvent être prévus avec une largeur WS2 (dimension mesurée parallèlement au plan à l'axe y) qui peut être prévue différente de la largeur WS1 celle des segments 141, 143. La largeur WS2 est comprise par exemple entre 10 nm et 2 µm. La largeur WS2 sera adaptée par l'homme du métier en fonction de la dimension minimale du nœud technologique pour la valeur minimale, et de la taille d'un faisceau de l'outil de scattérométrie divisée sensiblement par 20 pour la taille maximale.

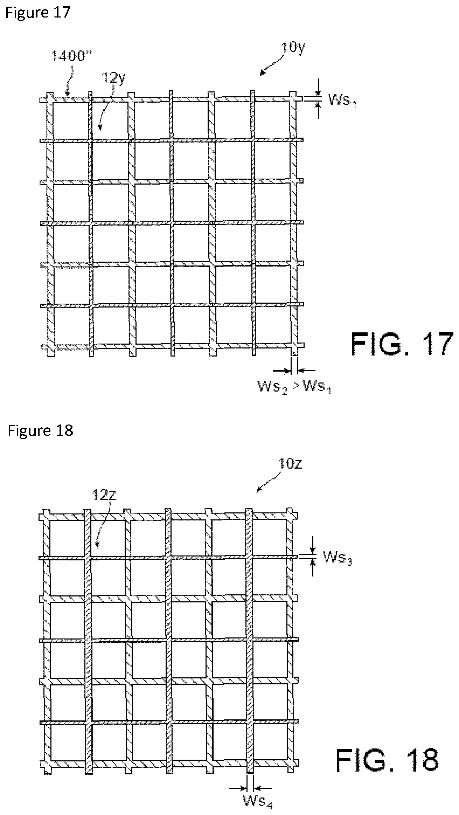

Lorsque le premier motif est prévu avec une largeur WS1 différente de la largeur WS2 il peut servir de détrompeur ou de repère d'orientation. C'est le cas par exemple sur la variante de réalisation illustrée sur la figure 17, où WS2 et WS1 sont prévus de sorte que WS2 > WS1.

Les segments 161, 162 du deuxième motif 16 sont quant à eux agencés parallèlement ou sensiblement parallèlement à un deuxième plan (plan situé au niveau N₂ et parallèle au plan [O ;x ;y] du repère orthogonal [O ;x ;y ;z] sur la figure 2), avec au moins un premier segment 161 du deuxième ensemble orthogonal à un deuxième segment 162 du deuxième ensemble de segments. Le deuxième motif 16 présente également avantageusement une symétrie selon deux axes orthogonaux.

Un segment 161 du deuxième motif qui s'étend dans une première direction peut être prévu avec une largeur WS3 (dimension mesurée parallèlement à l'axe y du repère orthogonal [O ;x ;y ;z]) comprise par exemple entre 10 nanomètres et 2 µm. La largeur WS3 sera adaptée par l'homme du métier en fonction de la dimension minimale du nœud technologique pour la valeur minimale, et de la taille d'un faisceau de l'outil de scattérométrie divisée sensiblement par 20 pour la taille maximale.

Un segment 162 du deuxième motif 16 qui s'étend dans une deuxième direction orthogonale à la première direction peut être prévu avec une largeur WS4 éventuellement différente de celle WS3 du segment 161 et comprise par exemple entre 10 nanomètres et 2 µm. La largeur WS4 sera adaptée par l'homme du métier en fonction de la dimension minimale du nœud technologique pour la valeur minimale, et de la taille d'un faisceau de l'outil de scattérométrie divisée sensiblement par 20 pour la taille maximale.

Lorsque le deuxième motif est prévu avec une largeur WS4 différente de la largeur WS3 il peut servir de détrompeur ou de repère d'orientation. C'est le cas par exemple pour la variante de réalisation particulière illustrée sur la figure 18 et où l'on prévoit WS4> WS3.

Sur la figure 2, les segments 161, 162 du deuxième motif 16 se joignent en un point qui correspond au barycentre G2 du premier motif et forment ici une croix dont les branches sont orthogonales ou sensiblement orthogonales. Par « sensiblement orthogonales » on entend ici et tout au long de la description qui réalisent entre eux un angle de 90° ou très proche de 90° et en particulier entre 85° et 95°.

Le premier ensemble de segments 141, 142, 143, 144 formant le premier motif 14 et le deuxième ensemble de segments 161, 162 formant le deuxième motif 16 sont avantageusement répartis de sorte qu'un axe A'A orthogonal ou sensiblement orthogonal au substrat 2 et passant par le point G2, passe par un point central intérieur au contour du premier motif. Lorsque les niveaux sont parfaitement superposés avec un recouvrement (overlay) nul, le point central G1 correspond au barycentre du premier motif 14. Il est parfois souhaité que deux niveaux soient décalés d'une valeur connue. Dans ce cas, si cette valeur est bien respectée et constante, le paramètre d'overlay est également nul mais les barycentres ne sont pas alignés.

En ce qui concerne l'agencement matriciel et le pas ou période de répartition de cibles élémentaires 12, on peut prévoir à titre d'exemple dans une première direction, par exemple horizontale, un pas V-P1 de répétition du premier motif 14 compris par exemple entre 20 nm et 2 µm, et un pas V-P2 de répétition du deuxième motif 16 compris par exemple entre 20 nm et 2 µm. Le pas V-P1 de répétition du premier motif 14 et le pas V-P2 de répétition du deuxième motif 16 sont de préférence prévus égaux.

On peut également prévoir à titre d'exemple dans une deuxième direction orthogonale à la première direction, par exemple verticale, un pas H-P1 de répétition du premier motif 14 compris par exemple entre 20 nm et 2 µm, et un pas H-P2 de répétition du deuxième motif 16 compris par exemple entre 20 nm et 2 µm du deuxième motif. Le pas H-P1 de répétition du premier motif 14 et le pas H-P2 de répétition du deuxième motif 16 sont également de préférence prévus égaux.

Avantageusement, et comme illustré sur la figure 1, on peut prévoir le pas H-P1 de répétition du premier motif 14 et le pas H-P2 de répétition du deuxième motif 16 dans la première direction, distincts du pas V-P1 de répétition du premier motif 14 et du pas V-P2 de répétition du deuxième motif 16 dans la deuxième direction orthogonale. Là encore, un tel agencement permet de distinguer à partir de la structure une direction horizontale d'une direction verticale.

Dans l'exemple particulier de réalisation de la figure 1, chaque motif du deuxième niveau N₂ d'une cible élémentaire 12 peut être relié à un motif du deuxième niveau N₂ d'une cible adjacente. De même, chaque motif du deuxième niveau N₂ d'une cible élémentaire 12 est relié à un motif du deuxième niveau N₂ d'une cible adjacente. La structure 10 de métrologie peut être ainsi prévue avec un agencement tel que l'ensemble des segments des cibles élémentaires du premier niveau N1 forme un premier maillage rectangulaire continu, tandis que l'ensemble des segments des cibles élémentaires du deuxième niveau N2 forme un deuxième maillage rectangulaire continu au-dessus du premier maillage et décalé par rapport au premier maillage par rapport à un axe normal au substrat 2 comme axe de référence.

Sur les figures 1 et 2, une allure schématique de cible élémentaire et de segments formant chaque cible élémentaire est donnée. Pour permettre des mesures supplémentaires, des dents sont avantageusement prévues de part et d'autre d'au moins un segment donné du premier motif et/ou du deuxième motif, en particulier au niveau de masques de photolithographie respectifs sur lesquels ce premier motif et ce deuxième motif sont susceptibles d'être agencés.

Ainsi, dans l'exemple illustré sur la figure 4A, le segment 161 du deuxième motif 16 est pourvu latéralement de dents 163, 165 réalisant une structure de peigne. La structure de peigne illustrée est munie de premières dents 163 situées d'un premier côté du segment 161 et de deuxièmes dents 165 situées d'un deuxième côté du segment 161 opposé au premier côté, chaque première dent 163 pouvant être, dans cet exemple de réalisation, agencée en regard d'une deuxième dent 165. Les dents sont typiquement des blocs du même matériau que celui des segments. La largeur WT des dents (dimension mesurée parallèlement à celle dans laquelle le segment s'étend et qui dans l'exemple de la figure 4A est parallèle à l'axe x du repère orthogonal [O ;x ;y ;z]) peut différer d'une dent à l'autre. De même, la longueur LT des dents (dimension mesurée orthogonalement à celle dans laquelle le segment s'étend et qui dans l'exemple de la figure 4A est parallèle à l'axe y) peut différer d'une dent à l'autre. On peut également prévoir un espacement gT mesuré entre deux dents adjacentes situées d'un même côté (dimension mesurée parallèlement à celle dans laquelle le segment s'étend et qui, dans l'exemple de la figure 4A, est parallèle à l'axe x) qui diffère entre paires des dents adjacentes.

En particulier, la largeur WT1 d'une dent 163 située du premier côté du segment 163 peut être éventuellement prévue différente de celle d'une dent 165 située du deuxième côté de le segment 163. Par exemple, les largeurs WT1 et WT2 de dent peuvent être comprises entre 10 nm et 200 nm.

De même, la longueur la longueur LT1 d'une dent 163 située du premier côté du segment 163 peut être éventuellement prévue différente de celle d'une dent 165 située du deuxième côté du segment 163. Par exemple, les longueurs LT1 et LT2 de dent peuvent être comprises entre 10 nm et 200 nm.

On peut également prévoir un espacement gT1 mesuré entre deux dents adjacentes situées du premier côté différent de celui gT2 mesuré entre deux dents adjacentes situées du deuxième côté. Par exemple, les espacements gT1 et gT2 entre dents adjacentes peuvent être comprises entre 10 nm et 200 nm.

Le fait d'avoir des largeurs WT1, et WT2 et/ou des longueurs LT1 LT2 distinctes et/ou des espacements gT1, gT2 distincts entre les 2 côtés du segment 161, peut permettre de mesurer des pentes différentes sur chacun des côtés du segment 161 et donc d'améliorer la sensibilité aux variations de focus.

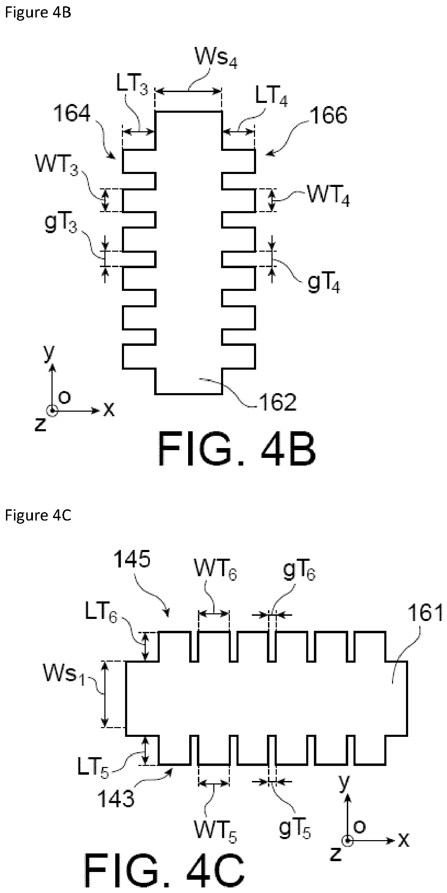

Sur la figure 4B, le segment 162 du deuxième motif 16 orthogonal ou sensiblement orthogonal au segment 161 est également pourvu de dents.

La structure de peigne comporte là encore des dents 164, 166 situées de part et d'autre du segment 162. Là encore, les largeurs LT3, LT4, espacements gT3, gT4, WT3, WT4 peuvent être modulées et éventuellement prévus différents d'un côté à l'autre du segment 162.

La présence possible de dents n'est pas limitée au deuxième motif. Ainsi, dans l'exemple illustré sur la figure 4C, au moins un segment 141 du premier motif 14 et qui s'étend ici parallèlement à une première direction, par exemple horizontale, est muni de dents 143, 145 réparties sur des côtés opposés du segment 141.

Les dents 143 situées d'un côté du segment 141 ont des dimensions respectives (longueur LT5, largeur WT5, espacement entre dents adjacentes gT5) qui peuvent également différer de celles (longueur LT6, largeur WT6, espacement entre dents adjacentes gT6) de dents 15 situées du côté opposé.

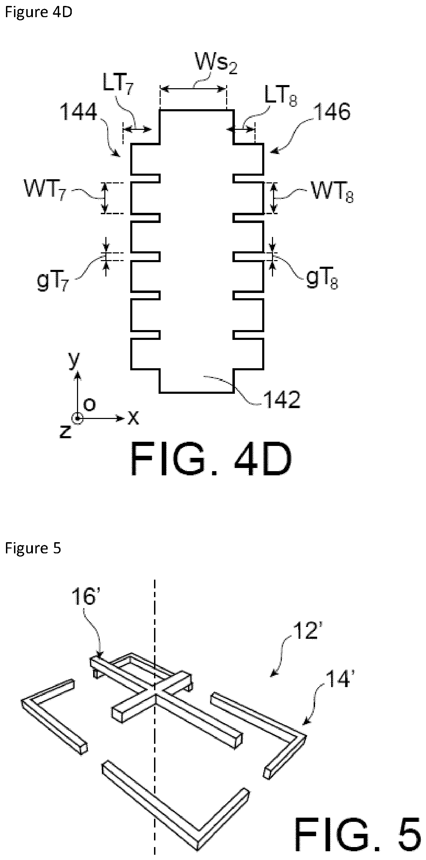

Sur la figure 4D, au moins un segment 142 du premier motif 14 et qui s'étend ici parallèlement à une deuxième direction, par exemple verticale est munie de dents 144, 146 réparties de chaque côté du segment 142, avec des dimensions WT7, WT8, LT7, LT8, gT7, gT8 qui peuvent différer d'un côté à l'autre du segment 142.

Les dimensions des dents LT, WT et espacements gT entre dents sont typiquement choisis inférieurs aux limites de résolutions d'un outil de photolithographie qui sert à exposer la structure sur un substrat. L'outil destiné à effectuer la détection du focus ne mesurera pas un peigne directement mais plutôt une forme résultante d'un manque de résolution typiquement un trapézoïde plus ou moins rugueux.

Ainsi, dans l'exemple particulier de la figure 4A, de même que sur les figures 4B-4C on illustre davantage des motifs en forme de peigne tels que réalisés sur masque de photolithographie que ceux de la structure de métrologie lorsqu'elle reproduite dans un empilement de couches minces.

Avec la structure 10 de métrologie, on peut effectuer une mesure de dimension critique de segments 141, 143, 161 horizontaux (i.e. qui s'étendent parallèlement à la première direction) et verticaux 142, 144, 162 (i.e. qui s'étendent parallèlement à la deuxième direction) des niveaux N1 et N2 par exemple par CD-SEM. Si l'on utilise une technique de scattérométrie, une déduction de la dimension critique des segments horizontaux 141, 143, 161 et verticaux 142, 144, 162 des niveaux N1 et N2 peut être réalisée en effectuant à la fois une mesure optique et une modélisation des motifs. Pour réaliser une mesure de recouvrement (overlay), une technique de balayage avec un faisceau d'électrons peut être par exemple utilisée ou par exemple une technique de scattérométrie peut être employée en effectuant une recherche de barycentres de modèles du premier motif du niveau N₁ et du deuxième motif du niveau N₂.

Une mesure d'angle entre des bords latéraux des motifs par rapport à une normale au plan principal du substrat peut (angle par rapport à l'axe z du repère orthogonal [O ;x ;y ;z] donné sur les figures 4A-4D), comme cela est décrit par exemple dans le document US10831107B2, donne quant à elle des indications de valeurs de focus ou à défaut des indications de stabilité du focus.

Une structure de métrologie suivant l'invention n'est pas nécessairement limitée au premier motif 14 et/ou au deuxième motif 16 décrits précédemment.

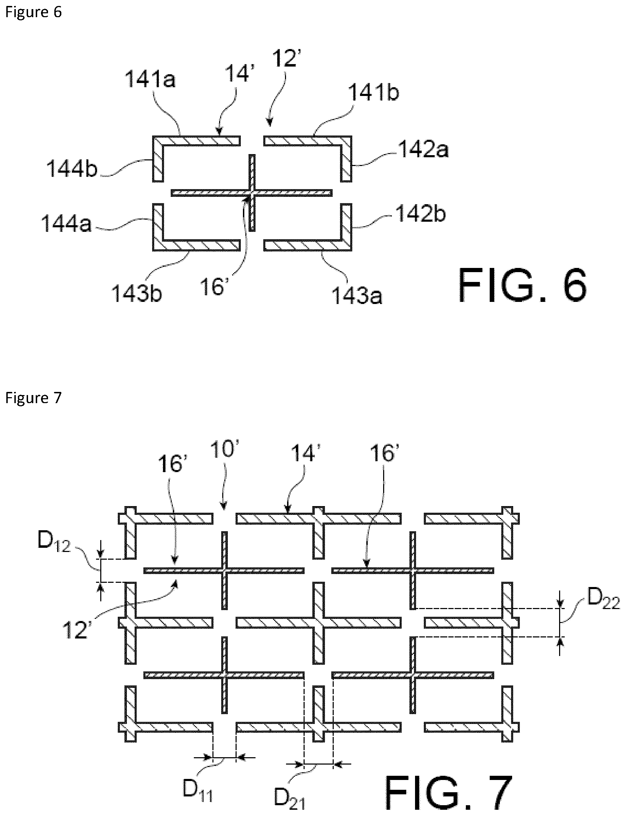

Ainsi, dans une variante de cible 12' élémentaire illustrée sur les figures 5 et 6 (donnant respectivement d'une vue de dessus et une vue en perspective), un autre motif 16' en forme de croix est prévu dans un niveau supérieur N₂, tandis que dans un niveau inférieur N₁, un motif 14' formé cette fois d'un ensemble de segments 141a, 141b, 142a, 142b, 143a, 143b, 144a, 144b et réalisant un cadre discontinu d'allure rectangulaire est prévu. Ce cadre est ici réalisé avec des paires 141a-141b, 142a-142b, 143a-143b, 144a-144b de segments orthogonaux ou sensiblement orthogonaux en forme de L.

Une structure 10' de métrologie illustrée sur la figure 7 prévoit ainsi un agencement matriciel avec une ou plusieurs rangées d'une telle variante de cible 12' élémentaire. Avec une telle structure on peut également exploiter des mesures de distance D21 entre deux motifs 16' adjacents et disjoints du deuxième niveau et situés dans une même première direction (correspondant dans l'exemple illustré à une direction horizontale de l'agencement matriciel), de distance D22 entre deux motifs 16' adjacents et disjoints du deuxième niveau et situés dans une même deuxième direction orthogonale à la première direction (la deuxième direction correspondant dans l'exemple illustré à une direction verticale de l'agencement matriciel). On peut également exploiter des mesures de distance D12, D11 entre deux portions adjacentes en forme de 'L' du premier motif 14'. Les distances D11, D12, D21, D22 peuvent être comprises typiquement entre 1 nm et 1µm. De telles mesures peuvent servir pour la modélisation physique des signaux.

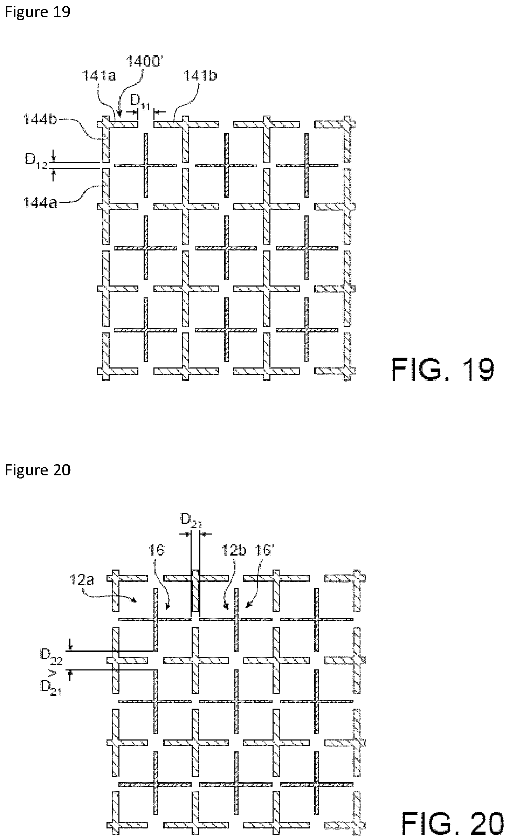

Les distances D₂₁ et D₂₂ peuvent être prévues différentes. Ainsi, dans l'exemple de réalisation particulier illustré sur la figure 20, dans une première direction, ici horizontale, un motif 16" d'une première cible élémentaire 12a et un motif 16" d'une deuxième cible élémentaire 12b adjacente (autrement dit voisine) de la première cible 12a sont espacés d'une première distance D₂₁ et dans lequel dans une deuxième direction, ici verticale, le motif 16" de la première cible élémentaire 12a et un motif d'une troisième cible élémentaire 12c adjacente ou voisine de la première cible 12a sont espacés d'une deuxième distance D₂₂ différente et en particulier supérieure à la première distance D₂₁. A l'aide de ces distances différentes D_{21,} D_{22,} on peut permettre à un équipement et/ou visuellement de distinguer une orientation verticale d'une orientation horizontale même lorsque le motif a une allure carrée.

Les distances D₁₁ et D₁₂ illustrées sur la figure 7 peuvent être également prévues différentes.

Ainsi, dans l'exemple de réalisation particulier illustré sur la figure 19, l'ensemble de segments formant un motif 1400' comporte, dans une première direction, ici horizontale, des segments 141a et 141b espacés entre eux d'une distance donnée D₁₁ et dans la deuxième direction des segments 141a, 141b espacés entre eux d'une autre distance D₁₂ distincte de ladite distance donnée.

Là encore, un tel agencement permet de faire une distinction entre une orientation selon la première direction et une orientation selon la deuxième direction, et ce, même lorsque le motif a une allure d'un contour de forme carrée.

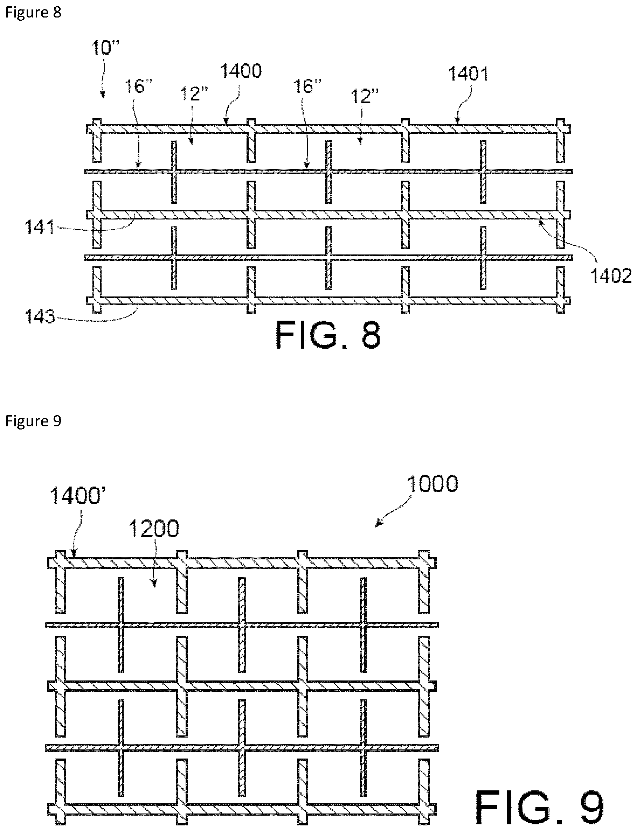

Une autre variante de structure 10" de métrologie illustrée sur la figure 8, diffère de celle décrite précédemment en lien avec la figure 7, notamment en ce que chaque motif 16" du deuxième niveau N₂ de la cible élémentaire 12" est relié à un autre motif 16" du deuxième niveau N₂ d'une cible élémentaire 12" adjacente et agencée sur une même rangée horizontale de cibles élémentaires 12".

Pour cette variante, le motif 1400 du premier niveau N₁ de la cible élémentaire réalise un contour de forme rectangulaire discontinu cette fois formé par deux portions 1401, 1402 en 'U' symétriques et en regard l'une de l'autre.

Ainsi, dans l'ensemble de segments du motif 1400 des segments 144a, 144b sont disjoints et espacés entre eux d'une distance donnée et dans une deuxième direction, le motif 1400 est formé de segments 141, 143 continus. Là encore, le motif 1400 permet de former un détrompeur dans le plan xy.

Une autre variante de structure 1000 de métrologie est illustrée sur la figure 9. La cible 1200 élémentaire diffère cette fois de la précédente en ce que le motif 1400' du premier niveau N₁, réalise un contour discontinu de forme carrée.

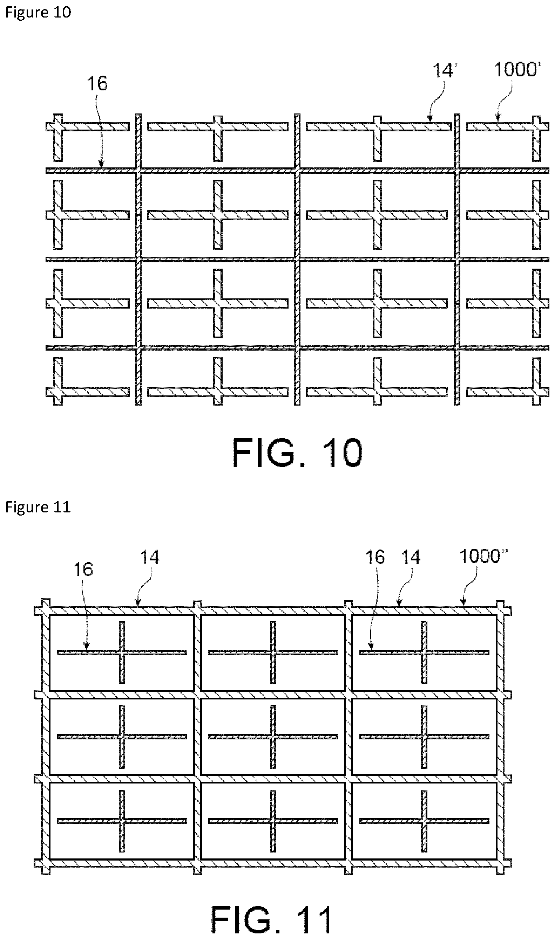

Une autre variante structure 1000' de métrologie illustrée sur la figure 10, diffère de celle décrite en lien avec la figure 7, en ce que les motifs 16 du deuxième niveau N₂ sont reliés entre eux.

Une autre variante structure 1000" de métrologie est donnée sur la figure 11. La cible diffère de celle décrite de celle décrite en lien avec la figure 7 de par le motif 14 du premier niveau qui suit ici un contour rectangulaire fermé comme dans l'agencement de la figure 1.

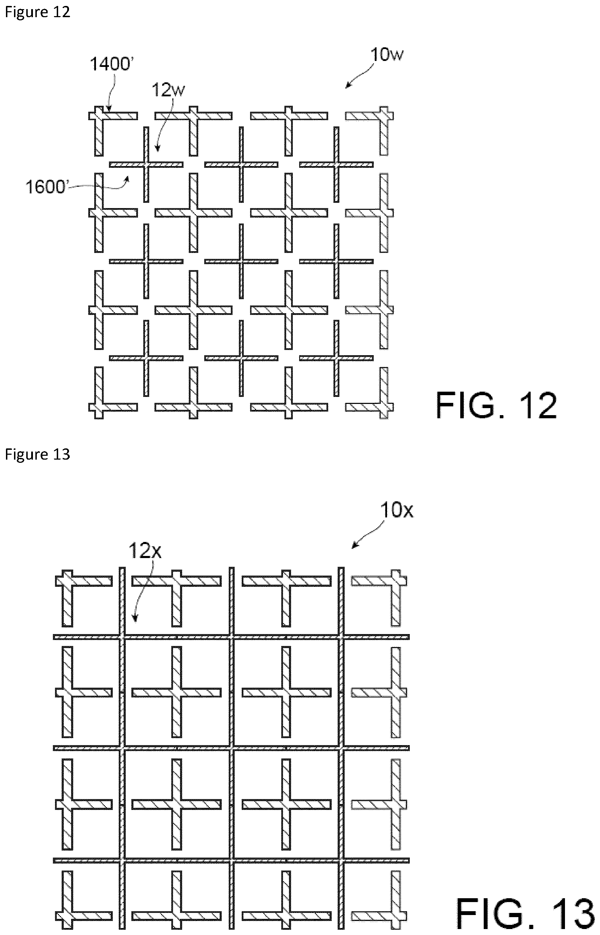

Dans l'exemple de structure 10w de métrologie illustrée sur la figure 12, chaque cible élémentaire 12w est formée d'un motif 1400' dans le premier niveau N₁ réalisant un contour discontinu de forme carrée et d'un motif 1600' du deuxième niveau N₂ en forme de croix.

Un autre exemple de structure 10x de métrologie est illustré sur la figure 13, dans lequel chaque cible élémentaire 12x est formée d'un motif dans le premier niveau N₁ réalisant un contour discontinu de forme carrée et d'un motif du deuxième niveau N₂ en forme de croix.

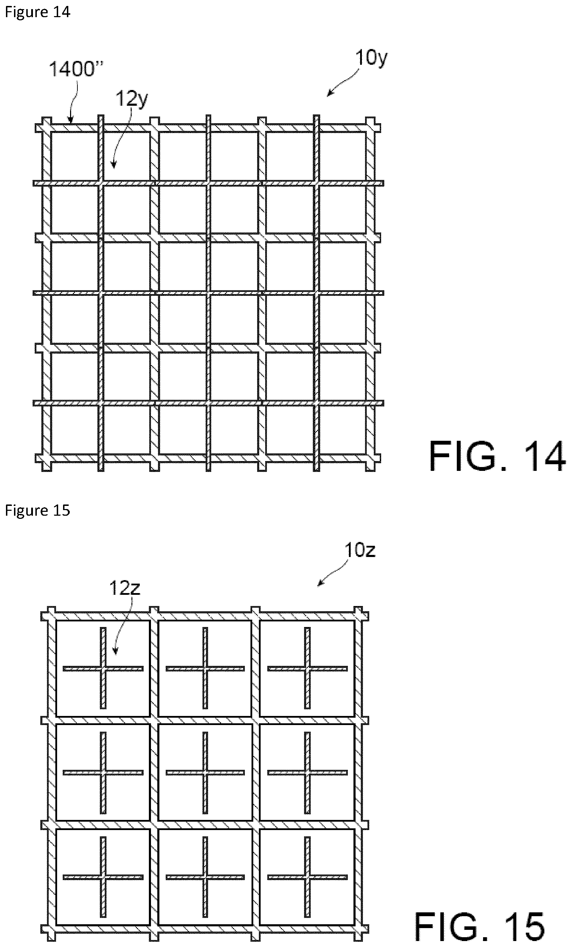

Dans l'exemple de structure 10y de métrologie illustrée sur la figure 14, chaque cible élémentaire 12y est formée d'un motif 1400" dans le premier niveau N₁ d'allure d'un carré discontinu et d'un motif du deuxième niveau N₂ en forme de croix.

Dans l'exemple de structure 10z de métrologie illustrée sur la figure 15, les motifs du deuxième niveau N₂ sont distincts et ne sont ainsi pas reliés entre eux.

Dans l'un ou l'autre des exemples décrits précédemment, les motifs réalisant un contour continu ou discontinu et rectangulaire ou carré, sont situés dans un niveau inférieur à celui dans lequel le motif en forme de croix est situé. Un agencement inverse est toutefois possible, avec le motif en forme de croix dans le niveau N₁ inférieur et le motif réalisant le contour dans le niveau N₂ supérieur.

En variante de l'un ou l'autre des exemples décrits précédemment et en particulier de ceux illustrés sur les figures 12 à 15 avec un motif en forme de contour carré, il est possible de prévoir un agencement avec des segments de largeurs différentes en fonction de leur orientation afin d'obtenir un détrompeur.

Ainsi, dans l'exemple de réalisation illustré sur la figure 17, des segments parallèles à une première direction sont prévus avec une largeur WS1, tandis que des segments parallèles à une deuxième direction ont une deuxième largeur WS2 différente et en particulier supérieure à la première largeur WS1.

Dans un autre exemple de réalisation illustré sur la figure 18, des segments parallèles à une première direction sont prévus avec une largeur WS3, tandis que des segments parallèles à une deuxième direction ont une largeur WS4 différente et en particulier supérieure à la première largeur WS3.

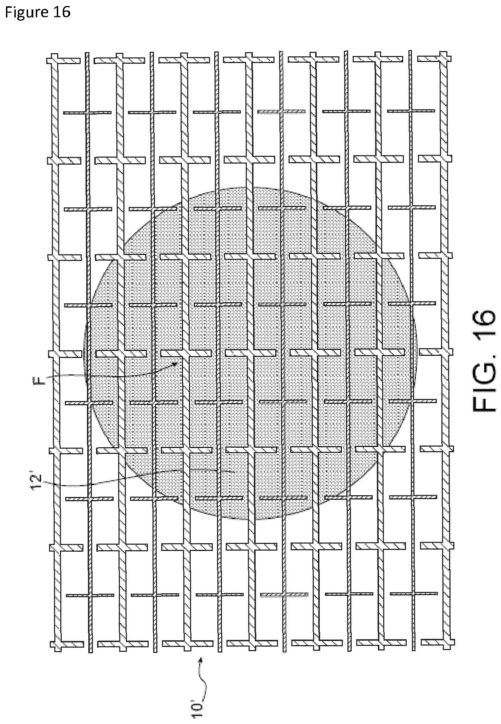

La figure 16 illustre de manière schématique une structure de métrologie 10' telle que décrite précédemment illuminée par un faisceau de rayonnement lumineux, par exemple IR ou UV d'un équipement de mesure ou de test pour pouvoir effectuer une mesure ou une détection telle qu'évoquée précédemment de dimension critique et/ou recouvrement (overlay) et/ou focus. Pour la scattérométrie, on prévoit le pas de répétition et la dimension des cibles élémentaires 12' pour pouvoir intégrer un nombre N suffisant de cibles dans la surface projetée du faisceau, par exemple d'au moins 10 et de préférence 20. Plus il y a de cibles dans la surface projetée du faisceau, meilleur sera le signal et on obtiendra une plus grande qualité de diffraction du faisceau lumineux.

Des motifs de cible élémentaire de structure de métrologie telle que décrite précédemment sont typiquement également réalisés sur des réticules de masque de photolithographie. Ainsi, un jeu de masques de photolithographie, avec un premier masque de photolithographie reprenant le premier motif 14 de cible 12 élémentaire et un deuxième masque de photolithographie reprenant le deuxième motif 16 de cible élémentaire 12 sont typiquement formés avant de réaliser la structure de métrologie dans un empilement de couches destinées à former un circuit intégré, avec un motif réalisé à un niveau N1 et deuxième motif à un niveau N1+k supérieur.

## Revendications

1. Structure (10, 10', 10", 1000, 1000', 1000") de métrologie formée sur au moins un support (2) et dotée de cibles (12, 12', 12", 12w, 12x, 12y) élémentaires identiques, lesdites cibles élémentaires étant réparties selon un agencement matriciel comportant parallèlement à une première direction, une ou plusieurs premières rangées de cibles élémentaires identiques et, parallèlement à une deuxième direction orthogonale à la première direction, une ou plusieurs autres rangées de cibles élémentaires identiques, chaque cible élémentaire comprenant un premier motif (14, 14', 1400, 1400') et un deuxième motif (16, 16',16") superposés,
- le premier motif étant formé d'un premier ensemble de segments (141, 142, 143, 144, 141a, 141b, 142a, 142b, 143a, 143b, 144a, 144b) agencés dans un premier plan et répartis le long d'un contour polygonal, en particulier rectangulaire ou carré,
- le deuxième motif étant formé d'un deuxième ensemble de segments (161, 162) agencés dans un deuxième plan parallèle ou sensiblement parallèle au premier plan et distinct du premier plan, les segments (161, 162) du deuxième ensemble étant répartis de sorte qu'un premier segment (161) du deuxième ensemble est orthogonal ou sensiblement orthogonal et joint en un point donné G2 un deuxième segment (162) du deuxième ensemble, de sorte à former une croix, **caractérisé en ce que** chacun desdits premier segment et deuxième segment du deuxième motif comportant des dents (163, 165, 164, 166, 143, 145, 144, 146) de part et d'autre, de sorte à former une structure de peigne sur chacun desdits premier et deuxième segments, la structure en forme de peigne comportant:
- une première dent (163) est agencée en regard d'une deuxième dent, la première dent étant prévue avec une première largeur WT1 mesurée parallèlement à une direction donnée, la deuxième dent étant prévue avec une deuxième largeur WT2 mesurée parallèlement à la direction donnée et différente de la première largeur.
et/ou
- une première dent (163) est agencée en regard d'une deuxième dent, la première dent étant prévue avec une première longueur LT1, la deuxième dent étant prévue avec une deuxième longueur LT2 différente de la première longueur LT1,
et/ou,
- des premières dents (163) adjacentes sont espacées deux à deux selon un premier espacement gT1 et des deuxièmes dents en regard des premières dents sont espacées deux à deux selon un deuxième espacement gT2, le premier espacement étant prévu différent du deuxième espacement.

2. Structure de métrologie selon la revendication 1, dans laquelle un segment donné appartenant au premier motif comporte également des dents de sorte à former une structure de peigne dans lequel une dent d'une première largeur est agencée en regard d'une autre dent d'une deuxième largeur différente de la première largeur,
et/ou
- une dent est d'une première longueur est agencée en regard d'une autre dent d'une deuxième longueur différente de la première longueur,
et/ou,
- des dents adjacentes sont espacées deux à deux selon un premier espacement gT1 et des deuxièmes dents en regard des premières dents sont espacées deux à deux selon un deuxième espacement, le premier espacement étant prévu différent du deuxième espacement.

3. Structure de métrologie selon l'une des revendications 1 ou 2, dans laquelle dans la première direction, le premier motif (14) et le deuxième motif (16) sont répétés selon un même premier pas V-P1, V-P2 de répartition et dans laquelle, dans la deuxième direction, le premier motif (14) et le deuxième motif (16) sont répétés selon un même deuxième pas H-P1, H-P2 de répartition, ledit premier pas V-P1, V-P2 de répartition étant différent dudit deuxième pas H-P1, H-P2 de répartition.

4. Structure de métrologie selon l'une des revendications 1 à 3, dans laquelle dans la première direction, un deuxième motif (16', 16") d'une première cible élémentaire (12', 12") est relié à un deuxième motif (16', 16") d'une deuxième cible élémentaire (12', 12") et dans laquelle dans ladite deuxième direction, ledit deuxième motif (16', 16") de ladite première cible élémentaire (12', 12") et un autre deuxième motif d'une troisième cible élémentaire (12' 12") sont disjoints.

5. Structure de métrologie selon la revendication 4, dans laquelle le deuxième motif (16', 16") de ladite première cible élémentaire et le deuxième motif (16', 16") de la deuxième cible élémentaire sont espacés d'une première distance D₂₁ et dans lequel dans la deuxième direction, le deuxième motif (16") de la première cible élémentaire (12") et ledit autre deuxième motif (16b) de ladite troisième cible élémentaire (12b) sont espacés d'une deuxième distance D₂₂ différente de la première distance.

6. Structure de métrologie selon l'une des revendications 1 à 5, dans laquelle ledit premier ensemble de segments dudit premier motif (1400') est formé, dans la première direction, de segments (141a, 141b) espacés entre eux d'une distance donnée D₁₁ et, dans la deuxième direction, de segments (144a, 144b) espacés d'une autre distance D₁₂ distincte de ladite distance donnée.

7. Structure de métrologie selon l'une des revendications 1 à 6, dans laquelle ledit premier ensemble de segments (141, 142, 143, 144) dudit premier motif est formé, dans la première direction, de segments (144a, 144b) espacés entre eux d'une distance donnée et dans la deuxième direction de segments continus.

8. Structure de métrologie selon l'une des revendications 1 à 7, dans laquelle le premier segment (161) et le deuxième segment (162) ont des largeurs respectives WS3,WS4 différentes, et/ou dans lequel des segments du premier ensemble de segments (141, 142, 143, 144) parallèles à la première direction ont une première largeur WS1 et des segments du premier ensemble de segments parallèles à la deuxième direction ont une deuxième largeur WS2 différente de la première largeur.

9. Structure de métrologie selon l'une des revendications 1 à 8, ledit premier ensemble de segments et le deuxième ensemble de segments étant répartis de sorte qu'un axe A'A orthogonal au support (2) et passant par ledit point donné G2, passe également par un point central G1 dudit contour polygonal.

10. Structure de métrologie selon l'une des revendications 1 à 9, dans laquelle ledit support est un substrat sur lequel un empilement de couches minces est formé, le premier motif étant réalisé dans une première couche mince dudit empilement, le deuxième motif étant réalisé dans une deuxième couche mince dudit empilement, la première couche mince et la deuxième couche mince étant situées à des niveaux distincts d'une superposition de niveaux dudit empilement.

11. Ensemble de masques de photolithographie formant une structure de métrologie selon l'une des revendications 1 à 10.

12. Procédé de fabrication d'un dispositif microélectronique ou d'un microsystème comprenant au moins une étape de mesure de dimension critique ou de recouvrement ou une étape de détection du focus d'un appareil de photolithographie au moyen d'une structure de métrologie selon l'une des revendications 1 à 11.

## Patentansprüche

1. Messstruktur (10, 10', 10", 1000, 1000', 1000"), die auf mindestens einem Träger (2) gebildet ist und mit identischen Elementarzielen (12, 12', 12", 12w, 12x, 12y) dotiert ist, wobei die Elementarziele in einer Matrixanordnung verteilt sind, die parallel zu einer ersten Richtung eine oder mehrere erste Reihen identischer Elementarziele und parallel zu einer zweiten, zur ersten Richtung orthogonalen Richtung, eine oder mehrere weitere Reihen identischer Elementarziele beinhaltet, wobei jedes Elementarziel ein erstes Motiv (14, 14', 1400, 1400') und ein zweites Motiv (16, 16', 16") umfasst, die übereinander angeordnet sind,
- wobei das erste Motiv aus einer ersten Anordnung von Segmenten (141, 142, 143, 144, 141a, 141b, 142a, 142b, 143a, 143b, 144a, 144b), die in einer ersten Ebene angeordnet und entlang einer polygonalen, insbesondere rechteckigen oder quadratischen Kontur verteilt sind, gebildet ist,
- wobei das zweite Motiv aus einer zweiten Anordnung von Segmenten (161, 162) gebildet ist, die in einer zweiten Ebene parallel oder im Wesentlichen parallel zur ersten Ebene angeordnet und von der ersten Ebene getrennt sind, wobei die Segmente (161, 162) der zweiten Anordnung verteilt sind, sodass ein erstes Segment (161) der zweiten Anordnung orthogonal oder im Wesentlichen orthogonal ist und an einem gegebenen Punkt G2 ein zweites Segment (162) der zweiten Anordnung verbindet, um ein Kreuz zu bilden, **dadurch gekennzeichnet, dass** jedes von dem ersten Segment und zweiten Segment des zweiten Motivs beiderseits Zinken (163, 165, 164, 166, 143, 145, 144, 146) beinhaltet, um auf jedem vom ersten und zweiten Segment eine Kammstruktur zu bilden, wobei die Struktur in Kammgorm beinhaltet:
- eine erste Zinke (163), die gegenüber einer zweiten Zinke angeordnet ist, wobei die erste Zinke mit einer ersten Breite WT1 vorgesehen ist, die parallel zu einer gegebenen Richtung gemessen wird, die zweite Zinke mit einer zweiten Breite WT2 vorgesehen ist, die parallel zur gegebenen Richtung gemessen wird und sich von der ersten Breite unterscheidet.
und/oder
- eine erste Zinke (163), die gegenüber einer zweiten Zinke angeordnet ist, wobei die erste Zinke mit einer ersten Länge LT1 vorgesehen ist, wobei die zweite Zinke mit einer zweiten Länge LT2 vorgesehen ist, die sich von der ersten Länge LT1 unterscheidet,
und/oder
- benachbarte erste Zinken (163), die paarweise in einem ersten Abstand gT1 beabstandet sind und zweite Zinken gegenüber den ersten Zinken paarweise in einem zweiten Abstand gT2 beabstandet sind, wobei die erste Beabstandung anders als die zweite Beabstandung vorgesehen ist.

2. Messstruktur nach Anspruch 1, wobei ein gegebenes Segment, das dem ersten Motiv angehört, auch Zinken beinhaltet, um eine Kammstruktur zu bilden, wobei eine Zinke einer ersten Breite gegenüber einer anderen Zinke einer zweiten Breite angeordnet ist, die sich von der ersten Breite unterscheidet,
und/oder
- eine Zinke einer ersten Länge gegenüber einer anderen Zinke einer zweiten Länge angeordnet ist, die sich von der ersten Länge unterscheidet,
und/oder
- benachbarte Zinken paarweise in einem ersten Abstand gT1 beabstandet sind und zweite Zinken gegenüber den ersten Zinken paarweise in einem zweiten Abstand beabstandet sind, wobei die erste Beabstandung anders als die zweite Beabstandung vorgesehen ist.

3. Messstruktur nach einem der Ansprüche 1 oder 2, wobei in der ersten Richtung das erste Motiv (14) und das zweite Motiv (16) mit demselben ersten Verteilungsschritt V-P1, V-P2 wiederholt werden und wobei in der zweiten Richtung das erste Motiv (14) und das zweite Motiv (16) mit einem gleichen zweiten Verteilungsschritt H-P1, H-P2 wiederholt werden, wobei sich der erste Verteilungsschritt V-P1, V-P2 vom zweiten Verteilungsschritt H-P1, H-P2 unterscheidet.

4. Messstruktur nach einem der Ansprüche 1 bis 3, wobei in der ersten Richtung ein zweites Motiv (16', 16") eines ersten Elementarziels (12', 12") mit einem zweiten Motiv (16', 16") eines zweiten Elementarziels (12', 12") verbunden ist und wobei in der zweiten Richtung das zweite Motiv (16', 16") des ersten Elementarziels (12', 12") und ein weiteres zweites Motiv eines dritten Elementarziels (12', 12") getrennt sind.

5. Messstruktur nach Anspruch 4, wobei das zweite Motiv (16', 16") des ersten Elementarziels und das zweite Motiv (16', 16") des zweiten Elementarziels in einem ersten Abstand D₂₁ voneinander beabstandet sind und wobei in der zweiten Richtung das zweite Motiv (16") des ersten Elementarziels (12") und das andere zweite Motiv (16b) des dritten Elementarziels (12b) in einem zweiten Abstand D₂₂ voneinander beabstandet sind, der sich vom ersten Abstand unterscheidet.

6. Messstruktur nach einem der Ansprüche 1 bis 5, wobei die erste Anordnung von Segmenten des ersten Motivs (1400') in der ersten Richtung aus Segmenten (141a, 141b) gebildet ist, die in einem gegebenen Abstand D₁₁ voneinander beabstandet sind, und in der zweiten Richtung aus Segmenten (144a, 144b) in einem anderen Abstand D₁₂ beabstandet sind, der sich von dem gegebenen Abstand unterscheidet.

7. Messstruktur nach einem der Ansprüche 1 bis 6, wobei die erste Anordnung von Segmenten (141, 142, 143, 144) des ersten Motivs in der ersten Richtung aus Segmenten (144a, 144b), die in einem gegebenen Abstand zueinander beabstandet sind und in der zweiten Richtung aus durchgehenden Segmenten gebildet ist.

8. Messstruktur nach einem der Ansprüche 1 bis 7, wobei das erste Segment (161) und das zweite Segment (162) jeweils unterschiedliche Breiten WS3,WS4 aufweisen, und/oder wobei Segmente der ersten Anordnung von Segmenten (141, 142, 143, 144) parallel zur ersten Richtung eine erste Breite WS1 aufweisen und Segmente der ersten Anordnung von Segmenten parallel zur zweiten Richtung eine zweite Breite WS2 aufweisen, die sich von der ersten Breite unterscheidet.

9. Messstruktur nach einem der Ansprüche 1 bis 8, wobei die erste Anordnung von Segmenten und die zweite Anordnung von Segmenten verteilt sind, sodass eine Achse A'A, orthogonal zum Träger (2) und durch den gegebenen Punkt G2 verlaufend, auch durch einen Mittelpunkt G1 der polygonalen Kontur verläuft.

10. Messstruktur nach einem der Ansprüche 1 bis 9, wobei der Träger ein Substrat ist, auf dem ein Dünnschichtstapel gebildet ist, wobei das erste Motiv in einer ersten Dünnschicht des Stapels ausgeführt ist, das zweite Motiv in einer zweiten Dünnschicht des Stapels ausgeführt ist, sich die erste Dünnschicht und die zweite Dünnschicht auf unterschiedlichen Niveaus einer Niveauüberlagerung des Stapels befinden.

11. Anordnung von Photolithographiemasken, die eine Messstruktur nach einem der Ansprüche 1 bis 10 bilden.

12. Verfahren zur Herstellung einer mikroelektronischen Vorrichtung oder eines Mikrosystems, das mindestens einen Schritt zum Messen einer kritischen Abmessung oder der Überdeckung oder einen Schritt zum Erfassen des Fokus eines Photolithografiegerätes mittels einer Messstruktur nach einem der Ansprüche 1 bis 11 umfasst.

## Claims

1. Metrology structure (10, 10', 10", 1000, 1000', 1000") formed on at least one support (2) and provided with identical elementary targets (12, 12', 12", 12w, 12x, 12y), said elementary targets being distributed according to a matrix arrangement comprising, parallel to a first direction, one or more first row(s) of identical elementary targets and, parallel to a second direction orthogonal to the first direction, one or more other row(s) of identical elementary targets, each elementary target comprising a first pattern (14, 14', 1400, 1400') and a second pattern (16, 16', 16") which are superimposed,
- the first pattern being formed by a first set of segments (141, 142, 143, 144, 141a, 141b, 142a, 142b, 143a, 143b, 144a, 144b) arranged in a first plane and distributed along a polygonal contour, in particular a rectangular or square contour,
- the second pattern being formed by a second set of segments (161, 162) arranged in a second plane parallel or substantially parallel to the first plane and different from the first plane, the segments (161, 162) of the second set being distributed so that a first segment (161) of the second set is orthogonal or substantially orthogonal and joins at a given point G2 a second segment (162) of the second set so as to form a cross, **characterised in that** each of said first segments and second segments of the second pattern comprising teeth (163, 165, 164, 166, 143, 145, 144, 146) on either side, so as to form a comb-shaped structure on each of said first and second segments, the comb-shaped structure comprising:
- a first tooth (163) is arranged facing a second tooth, the first tooth being provided with a first width WT1 measured parallel to a given direction, the second tooth being provided with a second width WT2 measured parallel to the given direction and different from the first width.
and/or
- a first tooth (163) is arranged facing a second tooth, the first tooth being provided with a first length LT1, the second tooth being provided with a second length LT2 different from the first length LT1,
and/or
- adjacent first teeth (163) are spaced apart two by two according to a first spacing gT1 and second teeth facing the first teeth are spaced apart two by two according to a second spacing gT2, the first spacing being provided to be different from the second spacing.

2. Metrology structure according to claim 1, wherein a given segment belonging to the first pattern also comprises teeth so as to form a comb structure, wherein a tooth with a first width is arranged opposite another tooth with a second width different from the first width,
and/or
- a tooth of a first length is arranged facing another tooth of a second length different from the first length,
and/or
- adjacent teeth are spaced apart two by two according to a first spacing gT1 and second teeth facing the first teeth are spaced apart two by two according to a second spacing, the first spacing being provided to be different from the second spacing.

3. Metrology structure according to either claim 1 or 2, wherein, in the first direction, the first pattern (14) and the second pattern (16) are repeated according to the same first distribution step V-P1, V-P2 and wherein, in the second direction, the first pattern (14) and the second pattern (16) are repeated according to the same second distribution step H-P1, H-P2, said first distribution step V-P1, V-P2 being different from said second distribution step H-P1, H-P2.

4. Metrology structure according to one of claims 1 to 3, wherein, in the first direction, a second pattern (16', 16") of a first elementary target (12', 12") is connected to a second pattern (16', 16") of a second elementary target (12', 12") and wherein, in said second direction, said second pattern (16', 16") of said first elementary target (12', 12") and another second pattern of a third elementary target (12', 12") are separate.

5. Metrology structure according to claim 4, wherein the second pattern (16', 16") of said first elementary target and the second pattern (16', 16") of the second elementary target are spaced apart by a first distance D₂₁ and wherein, in the second direction, the second pattern (16") of the first elementary target (12") and said other second pattern (16b) of said third elementary target (12b) are spaced apart by a second distance D₂₂ different from the first distance.

6. Metrology structure according to one of claims 1 to 5, wherein said first set of segments of said first pattern (1400') is formed, in the first direction, by segments (141a, 141b) spaced apart by a given distance D₁₁ and, in the second direction, segments (144a, 144b) spaced apart by another distance D₁₂ different from said given distance.

7. Metrology structure according to one of claims 1 to 6, wherein said first set of segments (141, 142, 143, 144) of said first pattern is formed, in the first direction, by segments (144a, 144b) spaced apart from each other by a given distance and, in the second direction, by continuous segments.

8. Metrology structure according to one of claims 1 to 7, wherein the first segment (161) and the second segment (162) have different respective widths WS3, WS4, and/or wherein segments of the first set of segments (141, 142, 143, 144) parallel to the first direction have a first width WS1 and segments of the first set of segments parallel to the second direction have a second width WS2 different from the first width.

9. Metrology structure according to one of claims 1 to 8, said first set of segments and the second set of segments being distributed so that an axis A'A orthogonal to the support (2) and passing through said given point G2 also passes through a central point G1 of said polygonal contour.

10. Metrology structure according to one of claims 1 to 9, wherein said support is a substrate on which a stack of thin layers is formed, the first pattern being formed in a first thin layer of said stack, the second pattern being made in a second thin layer of said stack, the first thin layer and the second thin layer being located at different levels of a layer superimposition of said stack.

11. Set of photolithography masks forming a metrology structure according to one of claims 1 to 10.

12. Method for manufacturing a microelectronic device or a microsystem comprising at least one step of measuring a critical dimension or of coverage or a step of detecting the focus of a photolithography apparatus by means of a metrology structure according to one of claims 1 to 11.
